# EUROPÄISCHE PATENTANMELDUNG

(11) **EP 1 052 078 A1**
(43) Veröffentlichungstag der Anmeldung: **15.11.2000**
(21) Anmeldenummer: 00108926.7
(22) Anmeldetag: 27.04.2000
(51) Int. Cl.: B29C 45/57, B29C 45/27

(54) **Individuelle Prozessteuerung im Werkzeug**

(30) Priorität: 08.05.1999 DE 19921427; 15.10.1999 DE 19949850
(71) Anmelder: HEKUMA Herbst Maschinenbau GmbH, 85386 Eching (DE)
(72) Erfinder: Herbst, Richard, 85386 Eching (DE)
(74) Vertreter: Witte, Alexander, Dr.-Ing.

(57) **Zusammenfassung**

Eine Spritzgießmaschine sowie ein Verfahren zum Spritzgießen von Kunststoffartikeln in deren Werkzeug (10) werden beschrieben. In dem Werkzeug (10) befinden sich Formhohlräume. Zu den Formhohlräumen führt eine Mehrzahl von Kanälen (32, 38a, 38b).. In Kanälen (32, 38a, 38b) sind Verschlußelemente (50) zum individuellen, ferngesteuerten Verschließen des jeweiligen Kanals (32, 38a, 38b) vorgesehen. Die Verschlußelemente (50) sind während des Betriebes der Spritzgießmaschine programmgesteuert fernsteuerbar. In mindestens einem der Kanäle (38a, 38b) sind stromabwärts des Verschlußelementes (50) eine Drucksteuerung (88) zum Einstellen des Drucks in einem in dem Kanal (38a, 38b) befindlichen Kunststoffmaterial vorgesehen.

## Beschreibung

Die Erfindung betrifft eine Spritzgießmaschine mit einem Werkzeug, mit in dem Werkzeug befindlichen Formhohlräumen und mit einer Mehrzahl von zu den Formhohlräumen führenden Kanälen, wobei in Kanälen Verschlußelemente zum individuellen Verschließen des jeweiligen Kanals vorgesehen sind, die während des Betriebes der Spritzgießmaschine programmgesteuert fernsteuerbar ist.

Die Erfindung betrifft ferner ein Verfahren zum Spritzgießen von Kunststoffartikeln in einem Werkzeug, mit in dem Werkzeug befindlichen Formhohlräumen und mit einer Mehrzahl von zu den Formhohlräumen führenden Kanälen, wobei vorzugsweise in Kanälen Verschlußelemente zum individuellen Verschließen des jeweiligen Kanals vorgesehen sind und die Verschlußelemente während des Betriebes der Spritzgießmaschine programmgesteuert ferngesteuert werden.

Eine Spritzgießmaschine der vorstehend genannten Art ist aus der US-Z-"POLYMER ENGINEERING AND SCIENCE", Vol. 37, Nr. 11, Seite 1865-1879 (1997) bekannt.

Bei der bekannten Spritzgießmaschine ist eine gleichzeitige Durchfluß- und Druckregelung für die flüssige Kunststoffschmelze an mehreren Punkten eines Kanalsystems eines Formwerkzeugs bekannt. Zu diesem Zweck sind bei der bekannten Spritzgießmaschine Kegelventile vorgesehen, die unmittelbar mit den Übergangsöffnungen zu den Formhohlräumen zusammenwirken. Die Ventile sind hydraulisch gesteuert, wobei sich die Aktuatoren im Bereich neben dem Einspritzzylinder der Spritzgießmaschine befinden. Zur Steuerung der Kegelventile sind Drucksensoren vorgesehen. Diese befinden sich einmal an den Formhohlräumen selbst, ein weiterer Drucksensor ist aber auch im zentralen Zuführkanal des Einspritzzylinders vorgesehen. Auf diese Weise kann näherungsweise die Druckdifferenz zwischen einer Position stromaufwärts und einer Position stromabwärts der Kegelventile gemessen und in Abhängigkeit von der Druckdifferenz die Einstellung der Kegelventile vorgenommen werden. Ferner sind Sollkurven für den Druck im Formhohlraum vorgesehen, so daß auch die Differenz des gemessenen Ist-Drucks zum Solldruck erfaßt und für die Regelung verwendet werden kann.

Die Kegelventile sind sowohl in der Einspritzphase wie auch in der Nachdrückphase im Einsatz. Hierzu wird ergänzend vorgeschlagen, daß man die Ventilglieder auch als Kolben einsetzen kann, um in der Nachdrückphase Kunststoffmasse in die Formhohlräume nachzudrücken. Diese Vorgehensweise wird jedoch ausdrücklich als ineffektiv bezeichnet, weil der Stellweg der Ventilglieder nur sehr gering ist und am Ende des Stellweges das Ventil verschlossen ist, so daß ein weiteres Nachdrücken nicht möglich ist.

Aus der US-Z-"PROCEEDINGS OF ANNUAL TECHNICAL MEETING OF THE SOCIETY OF PLASTICS ENGINEERS", Vol. 56, Seiten 414-418 (1998) ist eine weitere Beschreibung der vorstehend bereits erläuterten Spritzgießmaschine bekannt. Ergänzend ist dabei beschrieben, daß sich die Kegelventile auch im Bereich eines Zuführkanals befinden können, der zu diesem Zweck einen kegelförmigen Übergang aufweist, an den ein kegeliges Ventilglied anlegbar ist. Auch in diesem Falle sind Drucksensoren stromaufwärts und stromabwärts des Ventils vorgesehen und der Regelungsvorgang ist der gleiche wie bereits beschrieben.

Noch eine weitere Beschreibung der vorstehend bereits erwähnten Spritzgießmaschine findet sich auf der Website www.dynisco.com/hotrun/hotrun-techarticles-dynamic feed.stm (in der Ausgabe vom 05.05.99, 13.07 Uhr). Dort ist ergänzend beschrieben, daß man bei langgestreckten Formhohlräumen eine Vielzahl von räumlich verteilten Zuführöffnungen mit entsprechend vielen Kanälen vorsehen kann, wobei in den Kanälen jeweils Verschlußelemente in Form der bereits erwähnten Ventile vorgesehen sein können. Auf diese Weise kann man durch sequentielles Öffnen der Ventile erreichen, daß jeweils weitere Kunststoffmasse synchron mit der fortschreitenden Flußfront der Kunststoffmasse im Formhohlraum zugeführt wird.

Aus der FR-A-2 141 453 ist ein Werkzeug für eine Spritzgießmaschine mit mehreren Formhohlräumen bekannt. Bei einem beschriebenen Ausführungsbeispiel werden mehrere, untereinander gleiche Formhohlräume sternförmig von einem zentralen Zuführkanal versorgt. Die einzelnen Kanäle verjüngen sich im Übergangsbereich zum Formhohlraum. Jedem dieser Bereiche ist eine Kolben-Zylinder-Einheit zugeordnet, mit der in jedem einzelnen Formhohlraum ein Nachdrückvorgang ausgeübt werden kann.

Bei einer weiteren, aus der DE 195 46 875 bekannten Spritzgießmaschine wird ein sogenanntes Mehrfachwerkzeug verwendet, d.h. ein Werkzeug, in dem sich eine Mehrzahl von Formhohlräumen befindet, um in einem einzigen Einspritzzyklus eine entsprechende Vielzahl von Kunststoffartikeln herstellen zu können.

Die bekannte Spritzgießmaschine ist mit einem Anschluß für einen Plastifizierzylinder versehen. Von dem Anschluß führt ein internes Kanalsystem in einer ersten Hälfte des Werkzeugs über einzelne Ventile zu den Formhohlräumen. Mittels eines Steueranschlusses können die Ventile individuell betätigt werden, beispielsweise über eine Multiplex-Schaltung. Die Ventile können wahlweise jeweils einzeln oder auch in Gruppen schaltbar sein. Auf diese Weise ist es möglich, die Zufuhr von flüssiger Kunststoffschmelze in bestimmte Formhohlräume durch Betätigen der Ventile zu stoppen. Dies ist dann sinnvoll, wenn während eines Zyklus nur eine bestimmte Anzahl von Kunststoffartikeln hergestellt werden soll, die kleiner ist als die Anzahl der zur Verfügung stehenden Formhohlräume. Ferner kann es geschehen, daß in einzelnen Formhohlräumen des Werkzeugs Fehltunktionen auftreten, beispielsweise dadurch, daß bestimmte Formhohlräume beschädigt werden oder daß in bestimmten Formhohlräumen hergestellte Kunststoffartikel beim Auswerfen nicht ausgeworfen werden sondern sich im Formhohlraum verklemmen. In diesen Fällen ist es sinnvoll, für darauffolgende Einspritzvorgänge diese fehlerbehafteten Formhohlräume abzuschalten und nur noch mit den übrigen Formhohlräumen weiterzuarbeiten.

Für den letztgenannten Fall ist es aus der DE 30 30 263 C2 auch bekannt, manuell Ventile zu betätigen, die sich in Zuführkanälen für einzelne Formhohlräume eines Mehrfachwerkzeugs befinden.

Es ist bei Spritzgießmaschinen ferner bekannt, am Ende eines Einspritzzyklus eine Drucksteuerung vorzunehmen. Dies bedeutet, daß man auf die im Werkzeug und in den Zuführkanälen befindliche Kunststoffmasse einen vorbestimmten Druck ausübt. Im allgemeinen wird dabei auf die Kunststoffmasse ein Überdruck ausgeübt (sogenanntes "Nachdrücken"). Es ist aber auch bekannt, insbesondere in einer zweiten, an das Nachdrücken anschließenden Phase einen Unterdruck in der Kunststoffmasse zu erzeugen (sogenannter "Masserückzug").

Durch das Anlegen des Überdrucks wird bewirkt, daß zu der im Formhohlraum des Werkzeugs abkühlenden und dabei schrumpfenden Kunststoffmasse eine kleine Zusatzmenge aus dem Kanalsystem nachgedrückt, d.h. das erforderliche Volumen im Formhohlraum ergänzt wird. Durch das anschließende Anlegen eines Unterdrucks wird hingegen bewirkt, daß die Kunststoffmasse in den Kanälen zurückgezogen oder zumindest entlastet wird. Auf diese Weise erreicht man, daß ein unkontrolliertes Austreten von Kunststoffmasse bei geöffnetem Werkzeug verhindert wird, insbesondere im Bereich der Trennebene zwischen den in diesem Augenblick voneinander beabstandeten Werkzeughälften.

Aus der US 5 512 223 A ist eine Kunststoff-Spritzgießmaschine mit örtlichem Nachdrücken bekannt. Bei dieser bekannten Maschine verzweigt sich ein vom Einspritzzylinder kommender Zuführkanal in einer Radialebene und führt dort seitlich zu axial verlaufenden Kanälen, die wiederum zu Formhohlräumen führen. Die bekannte Maschine ist mit mehreren axial wirkenden Kolben bzw. Stiften verbunden. Ein erster Stift schiebt sich im axial verlaufenden und zum Formhohlraum führenden Kanal vor den seitlich ankommenden Zuführkanal und schiebt damit eine bestimmte Menge an Kunststoffmasse vor sich her, die zum Nachdrücken im Formhohlraum verwendet werden kann. Zum Formhohlraum führen daneben noch zwei weitere axiale Kolben, die mittels geeigneter Platten separat und nacheinander vorfahrbar sind. Im Ruhezustand befindet sich einer dieser Kolben mit seiner Stirnseite bereits in Flucht mit der Formhohlraumwandung, während ein weiterer, größerer Kolben im Ruhezustand etwas zurückgezogen ist, so daß er vor seiner Stirnseite etwas Kunststoffmaterial speichert, das dann nach dem Einspritzen wieder in den Formhohlraum geschoben werden kann, bis auch die Stirnseite dieses Kolbens mit der Formhohlraumwand fluchtet. Schließlich sind noch übliche Auswerferstifte vorgesehen, die ebenfalls axial betätigbar sind.

Bei dieser bekannten Maschine kann also der Druck im Formhohlraum durch drei verschiedene Kolben eingestellt werden, die zu unterschiedlichen Zeiten vorfahren, um einen Nachdrückvorgang im Hohlraum zu bewirken. Über einen Masserückzug ist dabei ebenso wenig angegeben wie über eine Drucksteuerung in einem zum Formhohlraum führenden Kanal.

Es ist ferner allgemein aus dem Stand der Technik der Spritzgießmaschinen bekannt, dem Spritzzylinder ein Ventil nachzuordnen, das in einer ersten Betriebsstellung den Spritzzylinder mit einem seitlichen Vorratszylinder verbindet, in dem ein Kolben läuft. Die flüssige Kunststoffmasse wird dabei zunächst in diesen seitlichen Vorratszylinder eingespritzt. Das Ventil wird dann so umgeschaltet, daß der Spritzzylinder abgesperrt ist, so daß darin sofort der nächste Spritzvorgang vorbereitet werden kann. Gleichzeitig verbindet das Ventil den Vorratszylinder mit dem zum Werkzeug führenden Kanal und der im Vorratszylinder befindliche Kolben schiebt die im Vorratszylinder befindliche flüssige Kunststoffmasse in das Werkzeug und damit in den Formhohlraum. Es ist bekannt, dabei den Kolben im Vorratszylinder zum Nachdrücken zu verwenden. Die Anordnung befindet sich dabei aber außerhalb des Werkzeugs.

Es sind weiterhin Spritzgießmaschinen bekannt, bei denen unmittelbar nach Abschluß des Einspritz- und Nachdrückvorganges ein zentrales Verschlußelement im Verbindungskanal zwischen Spritzzylinder und Werkzeug in seine Schließstellung gebracht wird. Die vorausgegangene Drucksteuerung bezieht sich dann auf das gesamte Volumen, das sich zwischen dem Spritzzylinder und den Übergangsöffnungen zwischen den Zuführkanälen und den Formhohlräumen befindet. Der Nachdrückvorgang wird nämlich in diesem Fall ausschließlich durch ein weiteres Vorfahren der Plastifizierschnecke im Spritzzylinder erreicht. Das Volumen umfaßt dabei das gesamte Kanalsystem zwischen Spritzzylinder und Formhohlräumen.

Dieses Kanalsystem ist bei modernen Spritzgießmaschinen als sogenanntes "Manifold", d.h. als geheiztes Verteilersystem, ausgebildet. Dieses Verteilersystem kann in mehreren Ebenen arbeiten, indem zunächst erste Kanäle zu Verzweigungspunkten führen, von denen dann jeweils zweite Kanäle zu Formhohlräumen oder zu weiteren Verzweigungspunkten führen usw.

Insbesondere bei großen Werkzeugen bilden die genannten Kanäle bzw. Kanalabschnitte ein relativ großes Volumen, so daß eine präzise Drucksteuerung nicht in jedem Falle möglich ist. Insbesondere ist eine individuelle Regelung des Kunststoffflusses, des Drucks und der Geschwindigkeit in den unterschiedlichen Bereichen des Werkzeugs nicht möglich.

Dies wirkt sich insbesondere dann nachteilig aus, wenn das Werkzeug unterschiedlich gestaltete Formhohlräume enthält, insbesondere Formhohlräume mit sehr unterschiedlichen Abmessungen und/oder sehr unterschiedlichem Volumen. Wenn man in diesem Fall den Einspritzvorgang z.B. auf den großen Formhohlraum auslegt, kann es geschehen, daß die Kunststoffmasse im kleinen Formhohlraum überdrückt wird, während im umgekehrten Fall dann, wenn der Einspritzvorgang auf den kleinen Formhohlraum hin ausgelegt wird, die Kunststoffeinspritzung im großen Hohlraum unzureichend sein kann. In der Praxis arbeitet man in derartigen Fällen daher mit Kompromißlösungen, die unbefriedigend sind.

Der Erfindung liegt die Aufgabe zugrunde, eine Spritzgießmaschine der eingangs genannten Art dahingehend weiterzubilden, daß diese Nachteile vermieden werden. Insbesondere soll der Einspritzvorgang bei komplexen Werkzeugen optimiert und dabei die Drucksteuerung, und zwar vorzugsweise sowohl im Bereich des Nachdrückens wie auch im Bereich des Masserückzuges, noch präziser und individueller ausgeführt werden können.

Bei einer Spritzgießmaschine der eingangs genannten Art wird diese Aufgabe erfindungsgemäß dadurch gelöst, daß in mindestens einem der Kanäle stromabwärts des Verschlußelementes eine Drucksteuerung zum Einstellen des Drucks in einem in dem Kanal befindlichen Kunststoffmaterial vorgesehen ist.

Bei einem Verfahren der eingangs genannten Art wird diese Aufgabe erfindungsgemäß dadurch gelöst, daß in mindestens einem der Kanäle der Druck in einem in dem mindestens einen Kanal befindlichen Kunststoffmaterial eingestellt wird.

Die der Erfindung zugrunde liegende Aufgabe wird auf diese Weise vollkommen gelöst.

Durch die genannten Maßnahmen ist es nämlich erstmals möglich, in einem Werkzeug mit unterschiedlichen Kanälen und/oder Formhohlräumen eine individuelle Anpassung von Kunststofffluß und Druck vorzunehmen, und zwar sowohl während des Einspritzvorganges wie auch während der nachfolgenden Drucksteuerung, sei es nur in Gestalt eines Nachdrückens und/oder auch in Gestalt eines Masserückzuges. Damit lassen sich Mehrfachwerkzeuge mit unterschiedlich gestalteten Formhohlräumen in optimaler Weise einsetzen, weil für jeden Formhohlraum und jedes Kanalsystem die jeweils optimalen Bedingungen individuell eingestellt werden können.

Die Erfindung hat insbesondere den Vorteil, daß sowohl ein genaues, gesteuertes Nachdrücken der Kunststoffmasse zur Kompensation des beim Abkühlen auftretenden Schwundes möglich ist, wie auch ein Masserückzug gegen Ende des Einspritzzyklus, durch den ein unkontrolliertes Austreten von Kunststoffmasse aus dem Heißkanal verhindert wird. Außerdem kann unmittelbar nach dem Beendigen des Einspritzens wieder plastifiziert werden, da der Nachdruck nicht über die Schnecke ausgeübt wird. Der Masserückzug kann unabhängig von dem Plastifiziervorgang zu jeder Zeit nach Abschluß des Nachdrückens ausgeführt werden.

Die erfindungsgemäße Spritzgießmaschine und ebenso das erfindungsgemäße Verfahren unterscheiden sich damit erheblich vom eingangs abgehandelten Stand der Technik.

Bei der in der US-Z-"POLYMER ENGINEERING ....." geschilderten Vorgehensweise wird nämlich auf halbem Wege stehengeblieben, weil zwar erkannt wurde, daß eine individuelle Steuerung des Flusses des Kunststoffmaterials vor den einzelnen Formhohlräumen zweckmäßig ist, andererseits ergibt sich trotz des sehr komplizierten Regelalgorithmus eine kaum beherrschbare Situation, weil durch das stetige Öffnen oder Schließen des Kegelventils nur eine Beeinflussung des Kunststoffflusses eintritt. Ein Verstellen des Kegelventils verändert dabei gleichzeitig mehrere Parameter, nämlich die Druckverhältnisse und damit über die Druckdifferenz auch die sogenannte "Scherung" des Kunststoffflusses, darüber hinaus aber auch die Temperatur. Damit ist ein gezieltes Regeln nicht möglich. Darüber hinaus hat dieses bekannte System, verglichen mit der vorliegenden Erfindung, den Nachteil, daß die Verbindung zum Plastifizierzylinder stets offenbleibt, so daß ein neuer Plastifiziervorgang erst dann eingeleitet werden kann, wenn die Kegelventile ihre geschlossene Endstellung erreicht haben. Dann ist jedoch ein Nachdrücken nicht mehr möglich, weil die Ventile vollkommen geschlossen sind. Ein geregeltes Nachdrücken mittels der dann als Kolben wirkenden Ventile ist zwar bei der bekannten Spritzgießmaschine angedeutet, in der Praxis aber nicht ausführbar. Dies liegt daran, daß infolge des konstant hohen Systemdrucks stromaufwärts der Kegelventile (bei offener Verbindung zum Plastifizierzylinder) ein "Nachdrücken" mittels der Ventilkörper nicht möglich ist. Solange nämlich die Ventilkörper noch von dem komplementären Ventilsitz abgehoben sind, kann ohnehin Kunststoffmasse über den dann noch bestehenden Ringspalt infolge des hohen Systemdrucks nachströmen. Auch hier gilt also, daß die stetige Verstellbarkeit der Kegelventile sich als nachteilig erweist, weil während der Verstellung der Kegelventile keine definierten Verhältnisse eingestellt werden können.

Nun ist zwar ergänzend aus der FR-A-2 141 453 bekannt, bei einem Mehrfachwerkzeug jedem einzelnen Formhohlraum eine Nachdrückeinheit zuzuordnen, auch diese vorgeschlagene Vorgehensweise bleibt jedoch, verglichen mit der vorliegenden Erfindung, auf halbem Wege stehen. Bei dieser bekannten Spritzgießmaschine bleibt nämlich ebenfalls die Verbindung zum zentralen Zuführkanal und damit zum hohen Betriebsdruck des Plastifizierzylinders, erhalten. Solange sich also die Nachdrückkolben aus ihrer Ruhestellung in den Kanalabschnitt hinein bewegen, der zum Formhohlraum führt, strömt ohnehin noch Kunststoffmaterial über das Kanalsystem nach. Infolge der kegeligen Ausbildung des Kanalabschnitts tritt dabei dann eine ähnliche Wirkung ein wie beim vorstehend beschriebenen System mit Kegelventilen, weil über eine gewisse Wegstrecke hinweg eine Regelventil-Charakteristik mit kontinuierlich verstellenden Eigenschaften vorliegt. Darüber hinaus sind bei dieser bekannten Spritzgießmaschine alle Formhohlräume gleich, so daß davon auszugehen ist, daß auch alle Kolben-Zylinder-Nachdrückeinheiten in gleicher Weise betätigt werden.

Demgegenüber gestattet es die Erfindung erstmals, das gesamte Kanalsystem im Werkzeug individuell zu verschließen, sei es insgesamt, d.h. unmittelbar stromabwärts der Plastifizierstrecke, sei es an ausgewählten Verteilerpunkten des Kanalsystems oder in einzelnen Kanalabschnitten. Die hierzu verwendeten Ventile sind vorzugsweise Schaltventile und keine Regelventile, weil sie lediglich die Funktion von Verschlußelementen haben, also nur zwischen den digitalen Zuständen "offen" und "geschlossen" hin- und hergeschaltet werden können. Sobald das Kanalsystem in der vorbestimmten Weise verschlossen wurde, ist der Plastifizierzylinder abgetrennt und es kann sich sofort eine neue Plastifizierphase anschließen, während noch im Werkzeug die weiteren Verfahrensschritte des Nachdrückens und des Masserückzuges ablaufen. Im Gegensatz zu den beiden vorstehend nochmals erläuterten Spritzgießmaschinen des Standes der Technik, aber auch im Gegensatz zu einer gedachten Kombination der Merkmale dieser beiden Maschinen, ist es beim Erfindungsgegenstand erstmals möglich, eine wirklich individuelle Drucksteuerung in einzelnen Kanalabschnitten, insbesondere in einzelnen Formhohlräumen durchzuführen. Diese Drucksteuerung ist erst dadurch möglich, daß zunächst individuell verschlossen wurde und dann, je nach Einzelfall und je nach Zeitpunkt des Verfahrens, der Druck in gewünschter Weise erhöht (Nachdrücken) bzw. vermindert (Masserückzug) werden kann.

Im Rahmen der Erfindung ist es insbesondere erstmals möglich, im Werkzeug selbst einen "Masserückzug" vorzunehmen. Dies war bislang nur mit Komponenten möglich, die sich außerhalb des Werkzeugs, insbesondere im Bereich des Einspritzzylinders befanden.

Dies ist bei keiner der beiden vorstehend nochmals erörterten Spritzgießmaschinen möglich und auch nicht bei einer Maschine, die gedanklich die Merkmale beider bekannter Maschinen aufweisen würde.

Bei einer bevorzugten Weiterbildung der Erfindung mit einem mindestens zwei Werkzeughälften umfassenden Werkzeug, bei dem ein Spritzzylinder mit Plastifizierschnecke an eine erste Werkzeughälfte anschließbar ist, ist die Drucksteuerung in der ersten Werkzeughälfte angeordnet.

Diese Maßnahme hat den Vorteil, daß das individuelle Absperren und/oder die individuelle Drucksteuerung in der sogenannten "heißen" Werkzeughälfte, nämlich in dem erwähnten Manifold, stattfindet, wo die Kunststoffmasse beim Einspritzen besonders niedrigviskos ist.

Bei einer noch weiteren Ausbildung dieser Ausführungsform ist die Drucksteuerung von einer zweiten Werkzeughälfte her betätigbar.

Diese Maßnahme hat den Vorteil, daß die Drucksteuerung völlig unabhängig von der Spritzgießmaschine selbst eingestellt werden kann, und zwar von der Seite des Werkzeugs, die vom Spritzzylinder abgewandt ist. Man kann dabei jedes Drucksteuerelement in hohem Maße spezifisch für jedes einzelne Werkzeug ausgestalten und ist nicht auf Elemente angewiesen, die sich ohnehin in der Spritzgießmaschine befinden und nur zusammen mit dieser einstellbar sind. Insbesondere ist eine gute Zugänglichkeit gewährleistet.

Bei einer weiter bevorzugten Ausführungsform der Erfindung ist die Drucksteuerung als in mindestens einen der Kanäle volumenverändernd ein- und/oder ausfahrbares Element, insbesondere als erstes Schraubelement ausgebildet.

Diese Maßnahme hat den Vorteil, daß eine besonders einfache Betätigung der Drucksteuerung möglich ist, indem das Schraubelement um seine Achse verdreht wird.

Mit unterschiedlichen Drehrichtungen kann dabei ein Einfahren bzw. ein Ausfahren des volumenverändernden Schraubelementes erreicht werden, so daß durch schlichte Drehrichtungsumkehr einmal ein Überdruck und zum anderen ein Unterdruck einstellbar ist.

Bei diesem Ausführungsbeispiel ist ferner bevorzugt, wenn das erste Schraubelement mindestens eine im wesentlichen unrunde Ausnehmung aufweist, wobei der Ausnehmung ein zur Ausnehmung komplementäres Betätigungselement gegenübersteht.

Diese Maßnahme hat insbesondere dann, wenn wiederum zwei einander gegenüberstehende Werkzeughälften verwendet werden, den Vorteil, daß beim Schließen des Werkzeugs das Betätigungselement selbsttätig in die Ausnehmung des Schraubzapfens greift, so daß auf diese einfache Weise die Betätigung des Schraubzapfens von der zweiten Werkzeughälfte her sichergestellt ist. Es ist jedoch auch eine Betätigung von anderer Seite her möglich.

Bei dieser Variante ist ferner bevorzugt, wenn ein Verschlußelement im Bereich eines Verzweigungspunktes der Kanäle angeordnet und das erste Schraubelement als das Verschlußelement umgebender hohler Schraubzylinder ausgebildet ist, der bei Betätigung in die vom Verzweigungspunkt abgehenden Kanäle einfährt.

Diese Maßnahme hat den Vorteil, daß eine gemeinsame Drucksteuerung für sämtliche von dem Verzweigungspunkt abgehenden dritten Kanäle möglich ist, sobald diese durch Betätigen des Verschlußelementes vom Plastifizierzylinder abgeblockt sind, wie noch erläutert werden wird. Ferner ergibt sich eine besonders platzsparende und kompakte, nämlich koaxiale Bauweise.

Eine alternative Ausführungsform sieht vor, daß das erste Schraubelement als Schraubzapfen ausgebildet ist, der bei Betätigung in einen Kanal einfährt.

Diese Maßnahme hat den Vorteil, daß eine Drucksteuerung für jeden einzelnen Kanal individuell möglich ist.

Bei einer weiteren Gruppe von Ausführungsbeispielen ist das Schraubelement mit einem selbsthemmenden Flachgewinde versehen.

Diese Maßnahme hat den Vorteil, daß das Schraubelement in jeder Betätigungsstellung selbsthemmend verharrt und sich auch dann nicht verstellt, wenn in axialer Richtung externer Druck ausgeübt wird. Insbesondere bei geöffnetem Werkzeug ändern die Schraubelemente ihre eingenommene Stellung nicht.

Bei einer weiteren Gruppe von Ausführungsbeispielen ist das Schraubelement mit einem Gewinde versehen, dessen Steigungswinkel so dimensioniert ist, daß das Schraubelement bei einer Verdrehung von wesentlich weniger als 360° zwischen seinen axialen Endstellungen einstellbar ist.

Diese Maßnahme hat den Vorteil, daß die Schraubelemente für die unterschiedlichen Funktionen koaxial zueinander angeordnet werden können, ohne daß dies größere konstruktive Probleme aufwirft.

Bei einer weiteren Gruppe von Ausführungsbeispielen sind die Verschlußelemente einzelnen Kanälen zugeordnet.

Diese Maßnahme hat den Vorteil, daß ein individuelles Absperren einzelner Kanäle möglich ist, wie dies an sich im Stand der Technik bekannt ist.

In diesem Falle ist jedoch besonders bevorzugt, wenn die einzelnen Kanäle zu einem gemeinsamen Formhohlraum führen.

Diese Maßnahme hat den Vorteil, daß der gemeinsame Formhohlraum durch unterschiedliche Ansteuerung der Verschlußelemente in den einzelnen Kanälen individuell aus mehreren Zugangsöffnungen, insbesondere unter zeitlicher Steuerung, ausgespritzt werden kann.

Dies gilt insbesondere dann, wenn die einzelnen Kanäle entlang einer Ausbreitungsrichtung einer Flußfront eines Kunststoffmaterials in den gemeinsamen Formhohlraum münden.

Es ist dann nämlich möglich, durch sequentielles Ansteuern der einzelnen Kanäle einen kontinuierlichen Einspritzvorgang auch in sehr langen und dünnen Formhohlräumen zu erreichen.

Wie bereits erwähnt wurde, ist besonders bevorzugt, wenn die Verschlußelemente Verzweigungspunkten für Kanäle zugeordnet sind.

Diese Maßnahme hat den Vorteil, daß mit einem einzigen Verschlußelement gleich eine Vielzahl von Kanälen versperrt werden kann, beispielsweise eine gesamte Kanalebene innerhalb eines Kanalsystems in einem Manifold.

Bei einer weiteren Gruppen von Ausführungsbeispielen ist jeweils mindestes ein Verschlußelement einer Anzahl, vorzugsweise einer Gruppen von Formhohlräumen zugeordnet.

Diese Maßnahme hat den Vorteil, daß die Gruppen individuell ausgespritzt werden können, insbesondere unter individueller zeitlicher Steuerung.

Vorzugsweise wird davon dann Gebrauch gemacht, wenn die Formhohlräume der einen Anzahl bzw. Gruppe in der Summe ihrer Volumina größer sind als die Formhohlräume der anderen Gruppe.

Diese Maßnahme ermöglicht es, bei Formhohlräumen unterschiedlicher Gestalt eine unterschiedliche Ansteuerung vorzunehmen.

Weiterhin ist erfindungsgemäß bevorzugt, wenn mindestens ein Verschlußelement stromaufwärts und/oder stromabwärts mit einem Sensor zusammenwirkt, der eine physikalische Größe einer am Verschlußelement vorbeiströmenden Kunststoffmasse erfaßt. Diese physikalische Größe kann z.B. der Druck, die Geschwindigkeit, die Temperatur oder eine Differenz oder ein Quotient dieser physikalischen Größen sein, insbesondere die Druckdifferenz der Kunststoffmasse über das Verschlußelement hinweg.

Diese Maßnahme hat den Vorteil, daß eine individuelle Steuerung des Flusses der Kunststoffmasse möglich ist, indem die genannten physikalischen Größen als Sollgrößen in einem Regelkreis eingesetzt werden.

Bei einer weiteren Gruppe von Ausführungsbeispiel mit einem mindestens zwei Werkzeughälften umfassenden Werkzeug, bei dem ein Spritzzylinder mit Plastifizierschnecke an eine erste Werkzeughälfte anschließbar ist, ist mindestens eines der Verschlußelemente in der ersten Werkzeughälfte angeordnet.

Diese Maßnahme hat den bereits erwähnten Vorteil, daß die Elemente in der sogenannten "heißen" Werkzeughälfte angeordnet sind, wo die Kunststoffmasse während des Einspritzvorganges besonders niedrigviskos ist.

Bevorzugt wird dieses Ausführungsbeispiel dadurch weitergebildet, daß ein erster Kanal im Spritzzylinder die Plastifizierschnecke mit einem zweiten Kanal der ersten Werkzeughälfte verbindet und der zweite Kanal an einem Verzweigungspunkt mit einer Mehrzahl dritter Kanäle in Verbindung steht, die in eine erste Vorderseite der ersten Werkzeughälfte münden, die einer zweiten Vorderseite einer zweiten Werkzeughälfte gegenübersteht, wobei ein Verschlußelement zwischen der Plastifizierschnecke und den dritten Kanälen angeordnet ist.

Diese Maßnahme hat den Vorteil, daß besonders kleine zu regelnde Volumina beim Absperren und der anschließenden Drucksteuerung entstehen.

In analoger Weise wie bereits oben für die Drucksteuerelemente ausgeführt, können auch die Verschlußelemente von der zweiten Werkzeughälfte her betätigbar und insbesondere als Schraubelemente, vorzugsweise Schraubzapfen, mit den bereits erwähnten konstruktiven Ausgestaltungen ausgebildet sein.

Besonders bevorzugt ist schließlich eine Anordnung, bei der die Plastifizierschnecke, der erste Kanal, der zweite Kanal, der Verzweigungspunkt und das Verschlußelement, insbesondere ein Schraubzapfen, in derselben Achse liegen.

Diese Maßnahme hat den Vorteil, daß ein besonders kompakter Aufbau des Werkzeugs entsteht.

Bei bevorzugten Weiterbildungen des erfindungsgemäßen Verfahrens, bei dem die Verschlußelemente Verzweigungspunkten für Kanäle zugeordnet sind, so daß jeweils mindestens ein Verschlußelement einer Anzahl, vorzugsweise einer Gruppe von Formhohlräumen zugeordnet ist, werden einzelnen Anzahlen bzw. Gruppen zugeordnete Verschlußelemente zeitlich nacheinander in ihre Offenstellung gesteuert, derart, daß die Formhohlräume der Anzahlen bzw. Gruppen alternierend mit Kunststoffmaterial ausgespritzt werden.

Es versteht sich dabei, daß in diesem Zusammenhang auch eine Anzahl von größer als zwei gewählt werden kann. Die Folge der Schritte kann daher nicht nur I, II, I, II... sein, sondern bspw. auch I, II, III, I, II, III... usw., und es ist auch denkbar, zunächst in I und II einzuspritzen und dann in I und II auszustoßen. Insoweit sind alle denkbaren kombinatorischen Vertauschungen möglich.

Gemäß einer ersten Variante dieses Ausführungsbeispiels sind die Formhohlräume der einen Gruppe andersartig, insbesondere in der Summe ihrer Volumina größer als die Formhohlräume der anderen Gruppe, wobei die der einen Gruppe zugeordneten Verschlußelemente zeitlich vor den der anderen Gruppe zugeordneten Verschlußelementen in ihrer Offenstellung geschaltet werden.

Diese Maßnahme hat den Vorteil, daß die Kunststoffartikel mit größerem Volumen zuerst gespritzt werden, so daß die dort eingespritzte größere Kunststoffmasse eine längere Zeit zur Verfügung hat, um abzukühlen.

Bei einer zweiten Variante werden die Anzahlen bzw. Gruppen zyklisch mit vorgegebener Zykluszeit angesteuert, wobei die Zyklen der Anzahlen bzw. Gruppen zueinander zeitlich versetzt sind. Dies gilt insbesondere dann, wenn nach dem Einspritzen der einen Gruppe zunächst die Kunststoffartikel der anderen Gruppe aus deren vorausgegangenem Zyklus entformt werden, daß dann die andere Gruppe eingespritzt wird und danach die zuvor in der einen Gruppe gespritzten Kunststoffartikel aus dieser entformt werden. Insbesondere wird nach dem Einspritzen der einen Gruppe vor dem Entformen der Kunststoffartikel der anderen Gruppe zunächst der in die eine Gruppe eingespritzte Kunststoff druckbehandelt und in einem vorgegebenen Ausmaß abgekühlt, ehe das Werkzeug zum Entformen der Kunststoffartikel der anderen Gruppe geöffnet wird.

Diese Maßnahme hat den Vorteil, daß durch ein definiertes zeitliches Versetzen der Zyklen zweier oder mehrerer parallel beaufschlagter Gruppen eine höhere Ausbringung erreicht wird, weil die Abkühlzeit in der einen Gruppe bereits für das Einspritzen in der anderen Gruppe sowie für das Plastifizieren zwischen den Einspritzvorgängen ausgenutzt werden kann.

Weitere Vorteile ergeben sich aus der Beschreibung und der beigefügten Zeichung.

Es versteht sich, daß die vorstehend genannten und die nachstehend noch zu erläuternden Merkmale nicht nur in der jeweils angegebenen Kombination, sondern auch in anderen Kombinationen oder in Alleinstellung verwendbar sind, ohne den Rahmen der vorliegenden Erfindung zu verlassen.

Ausführungsbeispiele der Erfindung sind in der Zeichnung dargestellt und werden in der nachfolgenden Beschreibung näher erläutert. Es zeigen:
- Fig. 1: einen Axialschnitt durch einen Teil eines Ausführungsbeispiels einer erfindungsgemäßen Spritzgießmaschine, in einer ersten Betriebsstellung;
- Fig. 2: die Spritzgießmaschine gemäß Fig. 1, jedoch in einer zweiten Betriebsstellung;
- Fig. 3a und 3b: als Ausschnitt eine erste Variante zum Ausführungsbeispiel gemäß Fig. 1a, 1b;
- Fig. 4a und 4b: eine Darstellung, ähnlich Fig. 3a, 3b, jedoch für eine weitere Variante der Erfindung;
- Fig. 5: eine Darstellung, ähnlich Fig. 1, jedoch für ein abgewandeltes Ausführungsbeispiel der Erfindung;
- Fig. 6: eine Ansicht in einer Radialebene, auf das Werkzeug gemäß Figuren 1 und 2;
- Fig. 7a) bis 7e): ein Zeitdiagramm zur Erläuterung eines bevorzugten Ausführungsbeispiels eines erfindungsgemäßen Spritzgießvorganges;
- Fig. 8: eine Seitenansicht, im Schnitt, durch ein weiteres Ausführungsbeispiel eines Werkzeugs;
- Fig. 9: in noch weiter vergrößertem Maßstab und im Schnitt eine weitere Variante eines Werkzeugs.

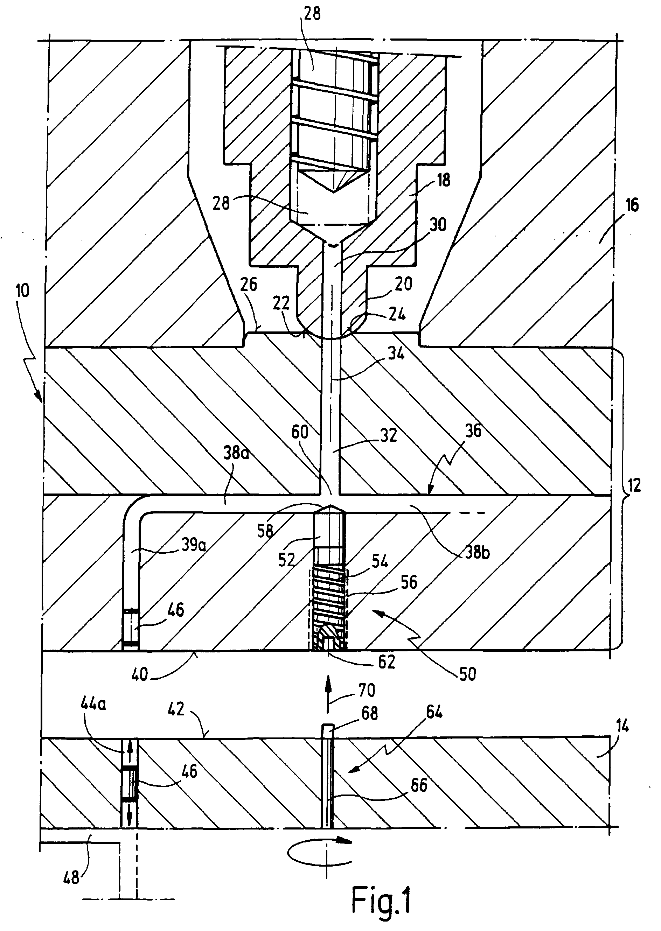

Fig. 1 zeigt einen Axialschnitt durch einen Teil einer Spritzgießmaschine. Mit 10 ist dabei ein Spritzgießwerkzeug bezeichnet, das aus einer ersten Werkzeughälfte 12 und einer zweiten Werkzeughälfte 14 besteht. Die erste Werkzeughälfte 12 ist auf einer Werkzeugaufspannplatte 16 montiert. An der von der ersten Werkzeughälfte 12 abgewandten Seite ist die Werkzeugaufspannplatte 16 mit einem Spritzzylinder 18 verbunden. Der Spritzzylinder 18 weist ein konisches Mundstück 20 auf, das in einen komplementären Aufnahmekonus 22 der Werkzeugaufspannplatte 16 eingeführt ist. Dabei stößt eine Stirnseite 24 des konischen Mundstücks 20 auf eine zugeordnete radiale Fläche 26 der Werkzeugaufspannplatte 16.

Im Spritzzylinder 18 befindet sich eine Plastifizierschnecke 28, die in Fig. 1a in der zurückgezogenen Stellung durchgezogen und in der vorgerückten Stellung strichpunktiert mit 28' eingezeichnet ist. Vom Bereich der Plastifizierschnecke 28 führt ein erster Kanal 30 zum Übergang 24/26 zwischen Spritzzylinder 18 und Werkzeugaufspannplatte 16 bzw. erster Werkzeughälfte 12. Der erste Kanal 30 setzt sich in der ersten Werkzeughälfte 12 in einem zweiten Kanal 32 fort. Die Plastifizierschnecke 28 und die Kanäle 30, 32 definieren dabei eine gemeinsame Achse 34, üblicherweise die Hauptachse des Spritzgießwerkzeugs 10.

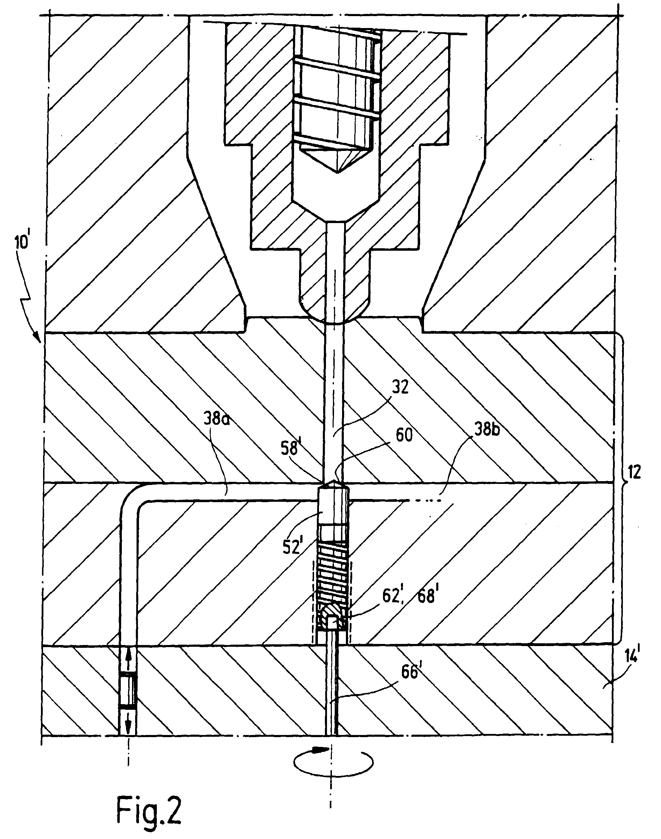

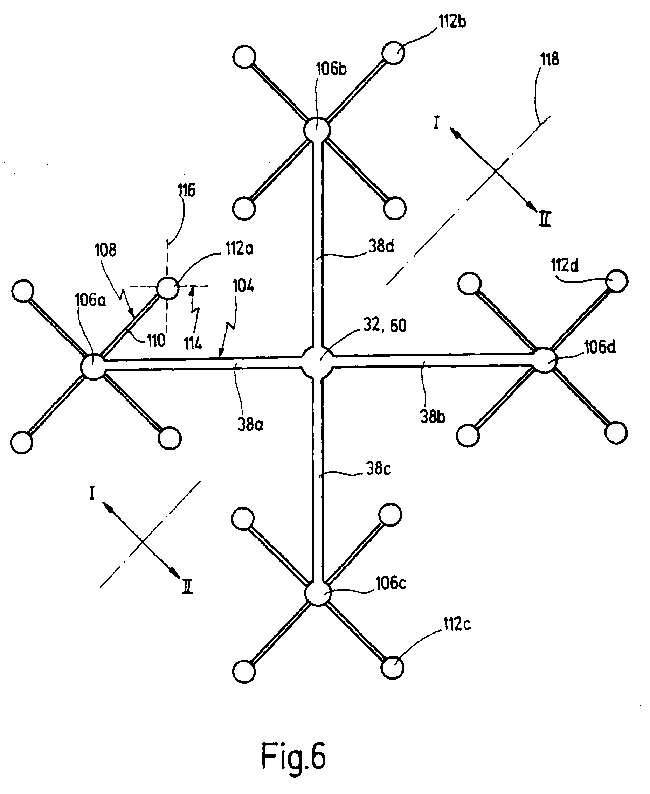

Der zweite Kanal 32 geht in der ersten Werkzeughälfte 12 in ein sogenanntes "Manifold" 36 über. Unter einem Manifold versteht man ein Kanal-Verteilersystem, das üblicherweise bei modernen Spritzgießwerkzeugen beheizt ist. Im dargestellten Ausführungsbeispiel besteht das Manifold 36 aus einer Vielzahl von dritten Kanälen 38a, 38b ..., die sich vom zweiten Kanal 32 zunächst in einer Radialebene verzweigen (vgl. dazu weiter unten zu Fig. 6), dann aber um 90° in eine axiale Richtung geleitet werden und schließlich mit Abschnitten 39a ... in einer ersten Vorderseite 40 der ersten Werkzeughälfte 12 ausmünden. Die erste Vorderseite 40 steht einer zweiten Vorderseite 42 der zweiten Werkzeughälfte 14 gegenüber. Fig. 1 zeigt den geöffneten Zustand des Spritzgießwerkzeugs 10, in dem die Werkzeughälften 12, 14 bzw. deren Vorderseiten 40, 42 voneinander beabstandet sind. Demgegenüber zeigt Fig. 2 den geschlossenen Zustand des Spritzgießwerkzeugs 10.

In der zweiten Werkzeughälfte 14 befinden sich vierte Kanäle 44a ..., von denen in Fig. 1 der Übersichtlichkeit halber nur einer dargestellt ist. Die vierten Kanäle 44a verlaufen in axialer Richtung und fluchten mit den in die erste Vorderseite 40 ausmündenden Abschnitten der dritten Kanäle 38a, 38b ... Die vierten Kanäle 44a ... führen in der zweiten Werkzeughälfte 14 zu Formhohlräumen, die in Fig. 1 der Übersichtlichkeit halber nicht dargestellt sind.

In den vierten Kanälen 44a ... können Kolben 46 laufen, die in an sich bekannter Weise dazu dienen, um am Ende des Einspritzvorganges die Kunststoffmasse im Übergang von den vierten Kanälen 44a ... zu den Formhohlräumen abzuscheren und/oder innerhalb der vierten Kanäle 44a ... eine Drucksteuerung für die dort befindliche Kunststoffmasse auszuführen. Derartige Kolbenanordnungen, die in der Fachwelt auch als "counter valve gate" bezeichnet werden, sind z.B. in der DE-A-196 17 768 beschrieben, auf die für weitere Einzelheiten verwiesen werden darf.

Bei bestimmten Spritzgießmaschinen des Standes der Technik war im ersten Kanal 30 ein Ventil vorgesehen. Dieses Ventil war Bestandteil des Spritzzylinders und daher auch von diesem her betätigbar.

Das Ventil hatte die Funktion, den ersten Kanal sogleich dann zu verschließen, wenn die Plastifizierschnecke durch kurzes Vorfahren einen "Schuß" Kunststoffmasse abgegeben hatte, und zwar über den ersten Kanal durch das zu diesem Zeitpunkt offene Ventil. Eine Drucksteuerung in dem vom Kanal 30 abgehenden Kanalsystem war dabei zwar möglich, jedoch nur in sehr grober Form, nämlich dadurch, daß die Plastifizierschnecke kurz vorgefahren wurde. Das Ventil mußte dann wieder verschlossen werden, damit im Spritzzylinder die Kunststoffmasse für den nächsten Schuß plastifiziert werden konnte. Ein anschließender Masserückzug durch Rückzug der Plastifizierschnecke war daher nicht möglich, weil das Ventil bereits geschlossen war.

Erfindungsgemäß kann nun auf dieses Ventil verzichtet werden. Die Funktion eines Verschlußelementes wird erfindungsgemäß in den Bereich der ersten Werkzeughälfte 12 verlagert. Bei dem in Figuren 1 und 2 dargestellten Ausführungsbeispiel ist ein Verschlußelement 50 in axialer Verlängerung des zweiten Kanals 32 vorgesehen. Das Verschlußelement 50 umfaßt im wesentlichen einen Schraubzapfen 52, der mindestens abschnittsweise mit einem Gewinde 54 versehen ist. Das Gewinde 54 ist vorzugsweise ein selbsthemmendes Flachgewinde. Das Gewinde 54 läuft in einem Gegengewinde 56 der ersten Werkzeughälfte 12.

Der Schraubzapfen 52 ist an seinem in Fig. 1 oberen Ende mit einer Spitze 58 versehen, die als Ventilglied wirkt. Die Spitze 58 steht einem ersten Verzweigungspunkt 60 zwischen dem zweiten Kanal 32 und den davon abgehenden dritten Kanälen 38a, 38b ... gegenüber. Der Verzweigungspunkt 60 wirkt dabei als Ventilsitz.

An dem in Fig. 1 unteren Ende ist der Schraubzapfen 52 mit einer unrunden Ausnehmung 62 versehen. Der Ausnehmung 62 bzw. dem Verschlußelement 50 als Ganzes steht in der zweiten Werkzeughälfte 14 ein Betätigungselement 64 gegenüber. Das Betätigungselement 64 umfaßt im wesentlichen einen Drehstab 66, der an seinem in Fig. 1 oberen Ende mit einem Vorsprung 68 versehen ist. Der Vorsprung 68 ist in seiner Formgebung komplementär zur unrunden Ausnehmung 62 im Schraubzapfen 52 ausgebildet.

Wenn die Werkzeughälften 12, 14 beim Schließvorgang des Spritzgießwerkzeugs 10 zusammengeführt werden, wie in Fig. 1 mit einem Pfeil 70 angedeutet, greift der Vorsprung 68 des Drehstabes 66 formschlüssig in die unrunde Ausnehmung 62 des Schraubzapfens 52.

Von der zweiten Werkzeughälfte 14 her kann nun der Drehstab 66 um die Achse 34 verdreht werden. Dies bewirkt, daß der Schraubzapfen 52 in axialer Richtung nach oben verfahren wird, bis seine Spitze 58 in Anlage an den ersten Verzweigungspunkt 60 kommt. Diese Situation ist in Fig. 2 dargestellt, wo die Bezugszeichen aller gegenüber Fig. 1 bewegten Elemente mit einem Apostroph versehen sind.

Man erkennt, daß der Schraubzapfen 52' den zweiten Kanal 32 nach unten hin, d.h. zur zweiten Werkzeughälfte 14' hin, dicht verschließt, also die dritten Kanäle 38a, 38b ... nach oben hin geblockt sind. Das für eine nachfolgende Drucksteuerung zu beaufschlagende Volumen ist damit gegenüber dem Stand der Technik deutlich vermindert, weil das Volumen des ersten Kanals 30 (teilweise) sowie des zweiten Kanals 32 jetzt nicht mehr durch die Drucksteuerung beaufschlagt werden. Diese bezieht sich vielmehr nur noch auf den Bereich stromabwärts des Verschlußelementes 50, d.h. auf die dritten Kanäle 38a, 38b ... sowie die vierten Kanäle 44a ...

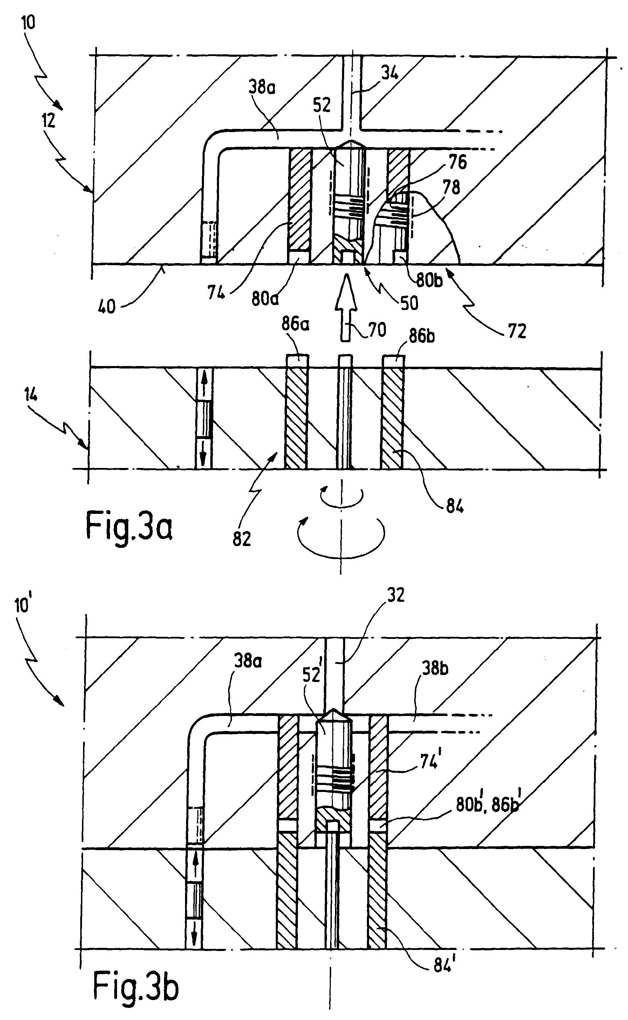

Die Figuren 3a und 3b zeigen im Ausschnitt eine Variante zum Ausführungsbeispiel gemäß Figuren 1 und 2; übereinstimmende Elemente sind dabei mit denselben Bezugszeichen versehen.

Bei der Variante gemäß Fig. 3a, 3b ist zusätzlich eine insgesamt mit 72 angedeutete Drucksteuereinrichtung vorgesehen. Die Drucksteuereinrichtung 72 umfaßt einen hohlen Schraubzylinder 74, der konzentrisch zum Schraubzapfen 52 angeordnet ist. Der Schraubzylinder 74 ist außen mit einem Gewinde, vorzugsweise ebenfalls einem selbsthemmenden Flachgewinde 76, versehen. Das Gewinde 76 läuft in einem Gegengewinde 78 der ersten Werkzeughälfte 12.

Der Schraubzylinder 74 ist an seiner in Fig. 3a unteren Seite mit Ausnehmungen 80a, 80b ... versehen, die in der ersten Vorderseite 40 der ersten Werkzeughälfte 12 liegen.

Dem Schraubzylinder 74 steht in der zweiten Werkzeughälfte 14 eine Betätigungseinrichtung 82 gegenüber. Die Betätigungseinrichtung 82 umfaßt einen Hohlzylinder 74. Der Hohlzylinder 74 ist an seinem in Fig. 3a oberen Ende mit Vorsprüngen 86a, 86b ... versehen. Diese Vorsprünge 86a, 86b ... sind komplementär zu den Ausnehmungen 80a, 80b ... ausgebildet.

Wie man aus Fig. 3b erkennt, wo wiederum die Schließstellung des Spritzgießwerkzeugs 10' dargestellt ist, greifen die Vorsprünge 86a, 86b ... beim Schließen des Spritzgießwerkzeugs 10 (Pfeil 70 in Fig. 3a) in die zugehörigen Ausnehmungen 80a, 80b ... des Schraubzylinders 74. Verdreht man nun den Hohlzylinder 84' (Fig. 3), so wandert der Schraubzylinder 74' nach oben (Fig. 3b) oder auch nach unten (nicht dargestellt).

Durch das Ein- bzw. Ausfahren des Schraubzylinders 74' wird das effektive Volumen in den dritten Kanälen 38a, 38b ... vermindert oder vergrößert. Im erstgenannten Fall wird somit ein Überdruck, im zweiten Fall ein Unterdruck eingestellt. Der Überdruck dient zum sogenannten Nachdrücken der Kunststoffmasse in den Formhohlraum hinein, um dadurch die bei der Abkühlung des Kunststoffmaterials eintretende Schrumpfung zu kompensieren. Das Einstellen des Unterdrucks hingegen bewirkt einen Masserückzug der Kunststoffmasse, so daß diese nicht mehr unkontrolliert aus dem Werkzeug austreten kann, wenn dieses beim Abschluß des Einspritzzyklus wieder geöffnet wird.

Beim Ausführungsbeispiel gemäß Fig. 3a, 3b bewirkt die konzentrische Anordnung des Schraubzylinders 74 um den Schraubzapfen 52 herum, daß alle dritten Kanäle 38a, 38b ..., die radial vom zweiten Kanal 32 abgehen und die insgesamt durch den nach oben verfahrenen Schraubzapfen 52 geblockt sind, in ihrem Volumen gleichermaßen beeinflußt werden, wenn sich der Schraubzylinder 74 dreht. Auf diese Weise wird somit eine Drucksteuerung gemeinsam für alle dritten Kanäle 38a, 38b ... ausgeübt.

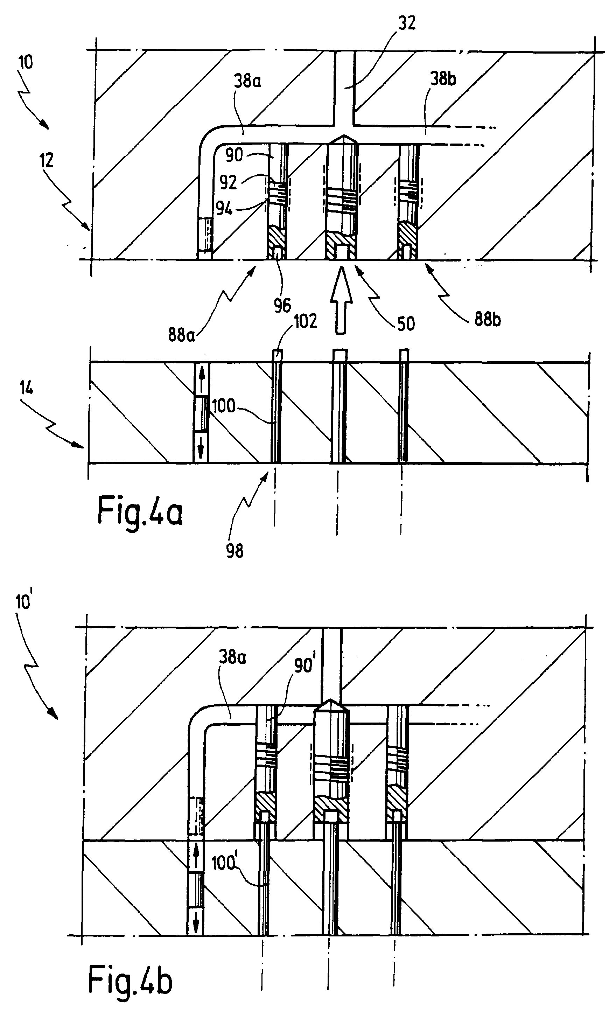

Im Gegensatz dazu zeigen die Figuren 4a und 4b eine Alternative zum Ausführungsbeispiel gemäß Figuren 3a und 3b, bei der es möglich ist, eine individuelle Drucksteuerung in den einzelnen dritten Kanälen 38a, 38b ... vorzunehmen.

Zu diesem Zweck ist einzelnen dritten Kanälen 38a, 38b ... jeweils ein individueller Schraubzapfen 90 mit Flachgewinde 92 zugeordnet, das jeweils in einem Gegengewinde 94 läuft, wie im Prinzip bereits beschrieben. Die Schraubzapfen 90 sind an ihrer Unterseite wiederum mit unrunden Ausnehmungen 96 versehen. In der zweiten Werkzeughälfte 14 befindet sich für jeden Schraubzapfen 90 ein Betätigungselement 98, umfassend einen Drehstab 100 mit oberem Vorsprung 102.

Wenn das Spritzgießwerkzeug 10' geschlossen wird (Fig. 4b), kann man somit durch individuelles Verdrehen der einzelnen Drehstäbe 100' die Schraubzapfen 90' ebenso individuell verstellen und damit für jeden einzelnen dritten Kanal 38a den darin herrschenden Druck individuell erhöhen oder vermindern.

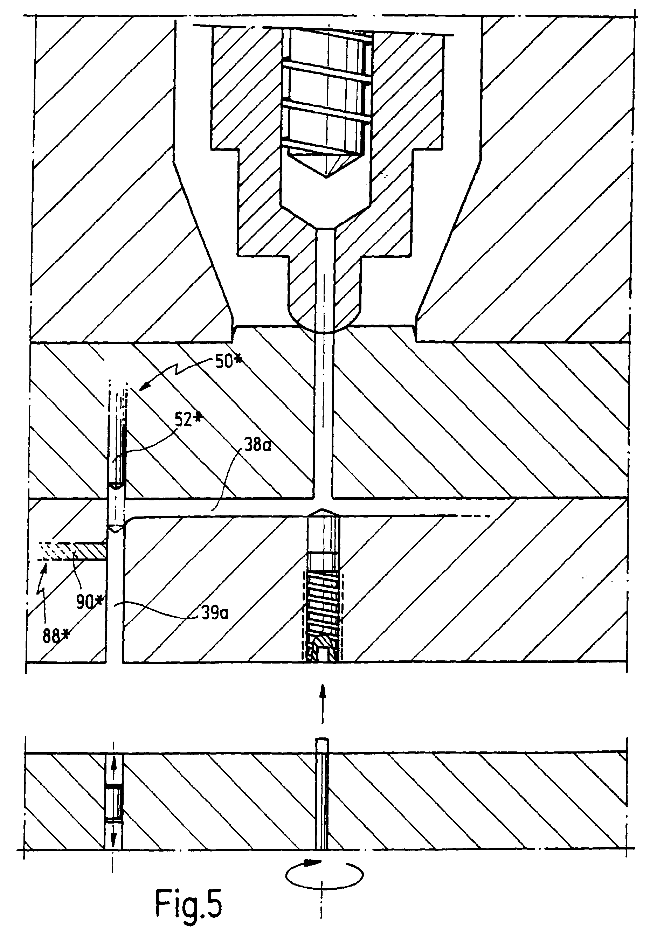

Fig. 5 zeigt eine Variante der Abbildung gemäß Fig. 1, bei der die an sich gleichen, jedoch anders positionierten Elemente mit denselben Bezugszeichen versehen sind wie in Fig. 1 und Fig. 4a, 4b, jedoch mit einem Sternchen gekennzeichnet sind.

Bei der Variante gemäß Fig. 5 wird nur der dritte Kanal 38a bzw. dessen abgewinkelter Abschnitt 39a individuell verschließbar und/oder drucksteuerbar ausgebildet.

Zu diesem Zweck ist ein Verschlußelement 50* oberhalb des Knies zwischen dem dritten Kanal 38a und dem Abschnitt 39a angeordnet, das im wesentlichen einen Schraubzapfen 52* umfaßt. Dieser Schraubzapfen 52* kann, wie strichpunktiert eingezeichnet, in das erwähnte Knie einfahren und damit den Kanal 38a/39a versperren, und zwar nur diesen individuell.

Weiterhin ist eine Drucksteuereinrichtung 88* vorgesehen, die seitlich neben dem Abschnitt 39a angeordnet ist. Ein Schraubzapfen 90* kann in Fig. 5 von links in den Abschnitt 39a ein- bzw. aus diesem auch herausgefahren werden, so daß in der bereits beschriebenen Weise eine Drucksteuerung möglich ist, und zwar wiederum individuell nur für den Kanal 38a/39a.

Fig. 6 zeigt schließlich eine äußerst schematisierte Ansicht auf das Kanalsystem in einer Radialebene.

Wie man leicht erkennt, gehen die dritten Kanäle 38a, 38b, 38c, 38d vom zweiten Kanal 32 am Verzweigungspunkt 60 in einer Radialebene ab, die als erste Verteilerebene 104 definiert werden kann. Die dritten Kanäle 38a, 38b, 38c, 38d führen wiederum zu zweiten Verzweigungspunkten 106, von denen in einer zweiten Verteilerebene 108 fünfte Kanäle 110 abgehen. Diese wiederum können zu dritten Verzweigungspunkten 112 führen, um eine dritte Verteilerebene 114 mit sechsten Kanälen 116 zu bilden usw.

Es versteht sich nun im Rahmen der vorliegenden Erfindung, daß die Verschlußelemente 50 an Verzweigungspunkten 60, 106, 112 beliebiger Verteilerebenen 104, 108, 114 angeordnet sein können oder auch an einzelnen Kanälen. Entsprechendes gilt für die Drucksteuereinrichtungen 72, 88, die ebenfalls an beliebigen Punkten des Kanalsystems gemäß Fig. 6 angeordnet werden können.

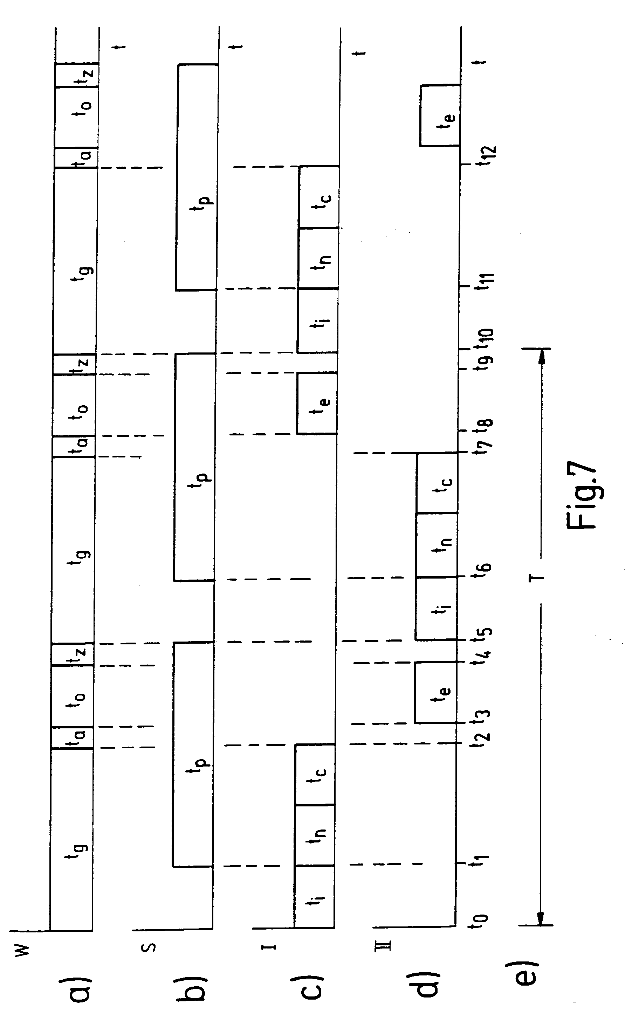

Fig. 7 zeigt in fünf Einzeldarstellungen a) bis e) ein Zeitdiagramm für zyklisch ablaufende Einspritzvorgänge gemäß der vorliegenden Erfindung.

Mit W ist dabei in Fig. 7a) der Zustand des Werkzeugs und mit S in Fig. 7b) der Zustand der Plastifizierschnecke bezeichnet. I und II in Fig. 7c) und Fig. 7d) kennzeichnen zwei Anzahlen bzw. Gruppen von Formhohlräumen in demselben Werkzeug. Unter "Anzahl" kann dabei auch lediglich ein derartiger Formhohlraum verstanden werden, während "Gruppe" eine Mehrzahl derartiger Formhohlräume bezeichnet. Im folgenden soll der Einfachheit halber nur von "Gruppe" gesprochen werden, auch wenn eine solche "Gruppe", wie erwähnt, nur aus einem Formhohlraum bestehen kann.

Schließlich ist unten in Fig. 7e) noch die Zykluszeit T eingetragen.

Ein Zyklus eines Einspritzvorganges beginne zum Zeitpunkt t₀. Das Werkzeug W befindet sich zu diesem Zeitpunkt und über diesen Zeitpunkt hinaus im geschlossenen Zustand, wie mit einer Schließzeit t_{g} angedeutet. Zum Zeitpunkt t₀ beginnt in der Gruppe I ein Einspritzvorgang, für den eine Zeit tᵢ benötigt wird. Zum Zeitpunkt t₁ ist der Einspritzvorgang abgeschlossen. Die Gruppe I wird nun durch Betätigen zugeordneter Verschlußelemente abgesperrt. Während einer Haltezeit tₕ schließt sich nun der Vorgang des Nachdrückens bzw. des Masserückzuges an, während gleichzeitig in der Plastifizierschnecke S ein neuer Plastifiziervorgang beginnt, der eine Zeit tₚ einnimmt.

In der Gruppe I schließt sich an die Haltezeit tₕ eine erste Abkühlzeit t_{c} an. Diese Zeit t_{c} ist so bemessen, daß nach deren Ablauf die Kunststoffartikel zwar noch nicht so weit abgekühlt sind, daß sie ausgeworfen bzw. entnommen werden könnten, die Kunststoffartikel sind jedoch so weit abgekühlt, daß man das Werkzeug öffnen kann. Dies ist zum Zeitpunkt t₂ der Fall. Während einer Zeit tₐ geht das Werkzeug W nun auf. Wenn das Werkzeug W offen ist, was während einer Zeit tₒ der Fall ist, können die im vorausgegangenen Zyklus in der Gruppe II gespritzten Kunststoffartikel entnommen werden, wofür von t₃ bis t₄ eine Zeit tₑ benötigt wird. Wenn alle Kunststoffartikel zum Zeitpunkt t₄ aus der Gruppe II entnommen sind, kann das Werkzeug W wieder schließen, wofür eine Zeit t₂ benötigt wird. Wenn das Werkzeug W geschlossen ist, nämlich zum Zeitpunkt t₅, beginnt ein Einspritzvorgang in der Gruppe II, wobei zum Zeitpunkt t₅ der Plastifiziervorgang in der Schnecke S abgeschlossen worden war. In der Gruppe II schließt sich nun von t₅ nach t₆ bis t₇ der gleiche Vorgang des Einspritzens (tᵢ), Haltens (tₕ) und vorläufigen Abkühlens (t_{c}) an, wie zuvor für Gruppe I beschrieben. Zugleich beginnt zum Zeitpunkt t₆ erneut ein Plastifiziervorgang in der Schnecke S, weil die Formhohlräume der Gruppe II ab dem Zeitpunkt t₆ wieder individuell abgesperrt worden sind.

Zum Zeitpunkt t₇ wird das Werkzeug W geöffnet (tₐ), woraufhin dann die zwischen t₀ und t₂ hergestellten Kunststoffartikel der Gruppe I entnommen werden können (tₑ), was von t₈ bis t₉ dauert. Während dessen dauert der Plastifiziervorgang in der Schnecke S noch an. Dies ist bis zum Zeitpunkt t₁₀ der Fall, wenn das Werkzeug W seinen Schließvorgang (t_{z}) beendet hat. Das System ist nun wieder am Ausgangspunkt (t₀) angelangt, die Zykluszeit T ist abgelaufen. Ab t₁₀ laufen dann wieder die gleichen Vorgänge ab wie ab dem Zeitpunkt t₀.

Durch die in Fig. 7 veranschaulichte Vorgehensweise ist eine bessere Auslastung des Werkzeugs möglich. Der zeitbestimmende Faktor ist nämlich unter anderem die Abkühlzeit für die Kunststoffartikel. Die gesamte Abkühlzeit der einen Gruppe kann nun in einer anderen Gruppe bereits ausgenutzt werden, weil die Kunststoffartikel der unterschiedlichen Gruppe jeweils in zeitlicher Überschneidung, d.h. bei zwei derartigen Gruppen alternierend, hergestellt werden. Zudem ergibt sich ein günstiger Zeitverlauf für die Plastifizierungsintervalle tₚ, die jeweils optimal früh einsetzen, so daß auch die Schnecke S zum jeweils erforderlichen Zeitpunkt wieder schußbereit ist.

In Fig. 7 wurde lediglich ein Ausführungsbeispiel mit zwei Gruppen I und II dargestellt. Selbstverständlich können auch mehrere Gruppen I, II, III jeweils nacheinander vorgesehen sein, wobei die in Fig. 7 dargestellte Schrittfolge entsprechend kombinatorisch zu erweitern ist. Alternativ ist auch denkbar, daß zunächst in zwei Gruppen eingespritzt und erst dann in diesen beiden Gruppen ausgestoßen wird, wobei auch hier wiederum zunächst in zwei ersten Gruppen eingespritzt, dann in zwei anderen Gruppen eingespritzt, dann in den zwei ersten Gruppen ausgestoßen und in den zwei anderen Gruppen ausgestoßen wird usw. Insoweit sind alle kombinatorischen Möglichkeiten denkbar.

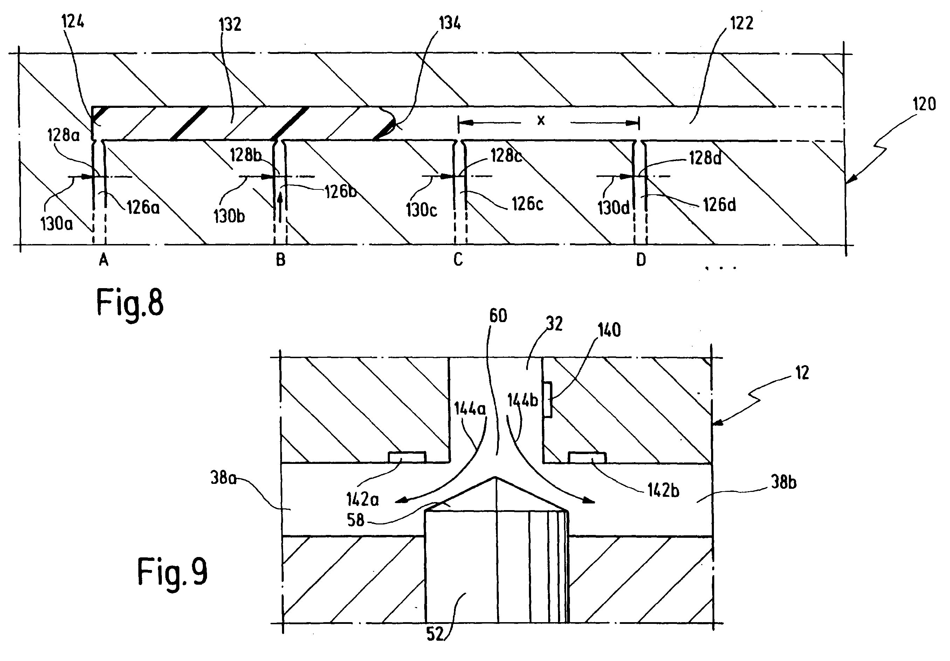

Bei der in Fig. 8 dargestellten Variante ist ein Werkzeug bei 120 angedeutet. Ein Formhohlraum 122 hat eine langgestreckte Gestalt. Bei derartigen Formhohlräumen 122 ist es oftmals schwierig, ein gutes Ergebnis zu erzielen, weil dann, wenn man den Kunststoff nur an einem Punkt einspritzt, dieser Kunststoff auf dem Wege durch den sehr langgestreckten Formhohlraum 122 abkühlt. Zwar ist es bekannt, derartig große oder langgestreckte Formhohlräume 122 gleichzeitig durch mehrere Öffnungen auszuspritzen, es entstehen dann aber Nahtstellen an den aufeinandertreffenden Flußfronten.

In Fig. 8 ist an einem linken Ende 124 ein erster Zuführkanal 126a angedeutet, in dem sich ein Ventil bzw. Verschlußelement 128a befindet, beispielsweise in Form einer Nadeldüse. Dieses Verschlußelement 128a kann individuell angesteuert werden, wie mit einem Steuereingang 130a angedeutet. Auch kann an dieser Stelle eine individuelle Drucksteuerung in einer der bereits beschriebenen Weisen vorgesehen werden, beispielsweise gemäß Fig. 4a, 4b oder Fig. 5. Der entsprechende Zugang zum Formhohlraum 122 ist in Fig. 8 gesamthaft mit A bezeichnet. Entsprechende weitere Zugänge B, C und D mit Zuführkanälen 126b, 126c, 126d, Verschlußelementen 128b, 128c, 128d und Steuereingängen 130b, 130c, 130d sind in Fig. 8 entlang der Länge des Formhohlraums 122 vorgesehen. Das Rastermaß zwischen zwei derartigen Zugängen A, B, C, D ist mit x bezeichnet.

Der Einspritzvorgang beginnt dadurch, daß zunächst nur über den Zugang A Kunststoff 132 eingespritzt wird. Dadurch bildet sich eine Flußfront 134, die in Fig. 8 von links nach rechts, d.h. von A nach D, fortschreitet. Durch zeitlich sequentielle Ansteuerung der Eingänge 130a bis 130d kann nun bewirkt werden, daß die Zugänge A, B, C, D ... nacheinander aktiviert werden, und zwar jeweils dann, wenn die Flußfront 134 an dem betreffenden Zugang A, B, C, D ... vorbeiläuft. Das Rastermaß X ist dabei so bemessen, daß die Flußfront 134 auf dem Wege x nicht unzulässig abkühlt. Auf diese Weise erreicht die Flußfront 134 den jeweils nächsten Zugang (im Beispielsfall der Fig. 8 Zugang C) dann, wenn die Flußfront 134 noch nahezu flüssig ist. Wenn dann der Zugang C aktiviert wird, gelangt aus ihm flüssige Kunststoffmasse 132 in die ebenfalls flüssige Flußfront 134, so daß Nahtstellen vermieden werden. Die dahinter liegenden Zugänge A und B können dann bei Bedarf wieder versperrt werden. Auf diese Weise können z.B. jeweils nur ein oder zwei Zugänge A, B, C, D ... durch Betätigung der Steuereingänge 130a bis 130d geöffnet sein.

Schließlich zeigt Fig. 9 noch eine Variante , die einen vergrößerten Ausschnitt aus dem Ausführungsbeispiel gemäß Fig. 1 darstellt. Man erkennt, daß im Bereich des Verzweigungspunktes 60 ein erster Sensor 140 in der Wand des zweiten Kanals 32 und zweite Sensoren 142a, 142b in den dritten Kanälen 38a, 38b angeordnet sind. Die Sensoren 140, 142 können unterschiedliche physikalische Parameter erfassen, beispielsweise den Druck, die Geschwindigkeit oder die Temperatur der vorbeiströmenden Kunststoffmasse, die in Fig. 9 mit den Pfeilen 144a, 144b angedeutet ist.

Durch geeignete Erfassung und Auswertung der Meßwerte der Sensoren 140, 142 kann nun ein Regelkreis aufgebaut werden. Der Regelkreis kann unmittelbar die erwähnten physikalischen Parameter auswerten oder auch Kombinationen davon, beispielsweise Differenzen oder Quotienten. Besonders bevorzugt ist, mit den Sensoren 140 einerseits und 142a, 142b andererseits die Druckdifferenz zu messen, die sich im Übergang zwischen den Kanälen 32 und 38 im Verzweigungspunkt 60 ausbildet, d.h. beim Vorbeilaufen der Kunststoffmasse an der Spitze 58 des als Verschlußelement 50 wirkenden Schraubzapfens 52. In Abhängigkeit von den Meßwerten bzw. daraus erzeugten Stellgrößen kann nun der Schraubzapfen 52 verstellt werden, so daß der Fluß der Kunststoffmasse und damit die Druckverhältnisse, mittelbar auch die Temperaturen, individuell eingestellt werden können.

Auf diese Weise läßt sich die sogenannte "Scherung" einstellen, d.h. der mechanische Schervorgang, der auf die Kunststoffmasse ausgeübt wird, wenn sie über das Druckgefälle an der Spitze 58 mit vorbestimmter Geschwindigkeit vorbei strömt. Die Scherung bewirkt dabei eine adiabatische Erwärmung der Kunststoffmasse, so daß in der erwähnten Weise mittelbar auch die Temperatur einstellbar ist.

Es versteht sich dabei, daß der anhand von Fig. 9 veranschaulichte Vorgang natürlich nicht auf Verzweigungspunkte beschränkt ist sondern auch an anderen Stellen des Kanalsystems eingesetzt werden kann, beispielsweise individuell für einzelne Kanäle oder einzelne Formhohlräume oder Gruppen davon.

## Patentansprüche

1. Spritzgießmaschine mit einem Werkzeug (10; 120), mit in dem Werkzeug (10; 120) befindlichen Formhohlräumen (48; 122) und mit einer Mehrzahl von zu den Formhohlräumen (48; 122) führenden Kanälen (32, 38, 39, 44; 110, 116; 126), wobei in Kanälen (32, 38, 39, 44; 110, 116; 126) Verschlußelemente (50; 128) zum individuellen Verschließen des jeweiligen Kanals (32, 38, 39, 44; 110, 116; 126) vorgesehen sind, die während des Betriebes der Spritzgießmaschine programmgesteuert fernsteuerbar sind, dadurch gekennzeichnet, daß in mindestens einem der Kanäle (38a, 38b, 38c, 38d; 110, 116; 126) stromabwärts des Verschlußelementes (50; 128) eine Drucksteuerung (72; 88) zum Einstellen des Drucks in einem in dem Kanal (38a, 38b, 38c, 38d; 110, 116; 126) befindlichen Kunststoffmaterial vorgesehen ist.

2. Spritzgießmaschine nach Anspruch 1, mit einem mindestens zwei Werkzeughälften (12, 14) umfassenden Werkzeug (10), bei dem ein Spritzzylinder (18) mit Plastifizierschnecke (28) an eine erste Werkzeughälfte (12) anschließbar ist, dadurch gekennzeichnet, daß die Drucksteuerung (72; 88) in der ersten Werkzeughälfte (12) angeordnet und vorzugsweise von einer zweiten Werkzeughälfte (14) her betätigbar ist.

3. Spritzgießmaschine nach Anspruch 1 oder 2, dadurch gekennzeichnet, daß die Drucksteuerung (72, 88) als in mindestens einen der Kanäle (38a, 38b, 38c, 38d; 110, 116) volumenverändernd ein- und/oder ausfahrbares Element vorzugsweise als erstes Schraubelement (84; 90) ausgebildet ist, wobei insbesondere das erste Schraubelement (84; 90) mindestens eine im wesentlichen unrunde Ausnehmung (80a, 80b; 96) aufweist und daß der Ausnehmung (80a, 80b; 96) ein zur Ausnehmung (80a, 80b; 96) komplementäres Betätigungselement (86a, 86b; 102) gegenübersteht.

4. Spritzgießmaschine nach Anspruch 3, dadurch gekennzeichnet, daß ein Verschlußelement (50) im Bereich eines Verzweigungspunktes (60) der Kanäle (38a, 38b, 38c, 38d) angeordnet und das erste Schraubelement (84) als das Verschlußelement (50) umgebender hohler Schraubzylinder (74) ausgebildet ist, der bei Betätigung in die vom Verzweigungspunkt (60) abgehenden Kanäle (38a, 38b, 38c, 38d) einfährt.

5. Spritzgießmaschine nach Anspruch 3, dadurch gekennzeichnet, daß das erste Schraubelement (90) als Schraubzapfen (100) ausgebildet ist, der bei Betätigung in einen Kanal (38a, 38b, 38c, 38d) einfährt.

6. Spritzgießmaschine nach einem oder mehreren der Ansprüche 1 - 5, dadurch gekennzeichnet, daß die Verschlußelemente (50; 128) einzelnen Kanälen (32, 38, 39, 44; 110, 116; 126) Verzweigungspunkten (60; 106, 112) für Kanäle (38; 110, 116; 126) zugeordnet sind.

7. Spritzgießmaschine nach einem oder mehreren der Ansprüche 1 bis 6, dadurch gekennzeichnet, daß jeweils mindestens ein Verschlußelement (50) einer Anzahl, vorzugsweise einer Gruppe (I, II) von Formhohlräumen zugeordnet ist, wobei weiter vorzugsweise die Formhohlräume der einen Anzahl bzw. Gruppe (I) andersartig, insbesondere in der Summe ihrer Volumina größer sind als die Formhohlräume der anderen Gruppe (II).

8. Spritzgießmaschine nach einem oder mehreren der Ansprüche 1 bis 7, dadurch gekennzeichnet, daß mindestens ein Verschlußelement (50) stromaufwärts und/oder stromabwärts mit einem Sensor (140, 142) zusammenwirkt, der eine physikalische Größe einer am Verschlußelement (50) vorbeiströmenden (144) Kunststoffmasse erfaßt, insbesondere den Druck oder die Geschwindigkeit oder die Temperatur der Kunststoffmasse.

9. Spritzgießmaschine nach Anspruch 8, dadurch gekennzeichnet, daß die physikalische Größe eine Differenz oder ein Quotient physikalischer Größen, insbesondere die Druckdifferenz der Kunststoffmasse über das Verschlußelement (50) hinweg ist.

10. Spritzgießmaschine insbesondere nach einem oder mehreren der Ansprüche 1 - 9, mit einem mindestens zwei Werkzeughälften (12, 14) umfassenden Werkzeug (10), bei dem ein Spritzzylinder (18) mit Plastifizierschnecke (28) an eine erste Werkzeughälfte (12) anschließbar ist, dadurch gekennzeichnet, daß mindestens eines der Verschlußelemente (50) in der ersten Werkzeughälfte (12) angeordnet ist, wobei vorzugsweise ein erster Kanal (30) im Spritzzylinder (18) die Plastifizierschnecke (28) mit einem zweiten Kanal (32) der ersten Werkzeughälfte (12) verbindet und der zweite Kanal (32) an einem Verzweigungspunkt (60; 106, 112) mit einer Mehrzahl dritter Kanäle (38a, 38b, 38c, 38d; 110, 116; 126) in Verbindung steht, die in eine erste Vorderseite (40) der ersten Werkzeughälfte (12) münden, die einer zweiten Vorderseite (42) einer zweiten Werkzeughälfte (14) gegenübersteht, und daß ein Verschlußelement (48; 50) zwischen der Plastifizierschnecke (28) und den dritten Kanälen (38a, 38b, 38c, 38d; 110, 116; 126) angeordnet ist.

11. Verfahren zum Spritzgießen von Kunststoffartikeln in einem Werkzeug (10; 120), mit in dem Werkzeug (10; 120) befindlichen Formhohlräumen (48; 122) und mit einer Mehrzahl von zu den Formhohlräumen (48; 122) führenden Kanälen (32, 38, 39, 44; 110, 116; 126), wobei vorzugsweise in Kanälen (32, 38, 39, 44; 110, 116; 126) Verschlußelemente (50; 128) zum individuellen Verschließen des jeweiligen Kanals (32, 38, 39, 44; 110, 116; 126) vorgesehen sind und die Verschlußelemente (50; 128) während des Betriebes der Spritzgießmaschine programmgesteuert ferngesteuert werden, dadurch gekennzeichnet, daß in mindestens einem der Kanäle (38a, 38b, 38c, 38d; 110, 116; 126) der Druck in einem in dem mindestens einen Kanal (38a, 38b, 38c, 38d; 110, 116; 126) befindlichen Kunststoffmaterial eingestellt wird.

12. Verfahren nach Anspruch 11, dadurch gekennzeichnet, daß der Druck mittels mindestens eines in einen der Kanäle (38a, 38b, 38c, 38d; 110, 116) volumenverändernd einfahrbaren zweiten Schraubelementes (84; 90) als Überdruck oder als Unterdruck eingestellt wird.

13. Verfahren, insbesondere Anspruch 11 oder 12, bei dem die Verschlußelemente (50; 128) Verzweigungepunkten (60; 106, 112) für Kanäle (38; 110, 116; 126) zugeordnet sind, so daß jeweils mindestens ein Verschlußelement (50) einer Anzahl, vorzugsweise einer Gruppe (I, II) von Formhohlräumen zugeordnet ist, dadurch gekennzeichnet, daß einzelnen Anzahlen bzw. Gruppen (I, II) zugeordnete Verschlußelemente (50) zeitlich nacheinander in ihre Offenstellung gesteuert werden, derart, daß die Formhohlräume der Anzahlen bzw. Gruppen (I, II) alternierend mit Kunststoffmaterial ausgespritzt werden können.

14. Verfahren nach Anspruch 13, bei dem die Formhohlräume der einen Gruppe (I) andersartig, insbesondere in der Summe ihrer Volumina größer sind als die Formhohlräume der anderen Gruppe (II), dadurch gekennzeichnet, daß die der einen Gruppe (I) zugeordneten Verschlußelemente (50) zeitlich vor den der anderen Gruppe (II) zugeordneten Verschlußelementen (50) in ihre Offenstellung geschaltet werden.

15. Verfahren nach Anspruch 13 oder 14, dadurch gekennzeichnet, daß die Anzahlen bzw. Gruppen (I, II) zyklisch mit vorgegebener Zykluszeit (T) angesteuert werden und daß die Zyklen der Anzahlen bzw. Gruppen (I, II) zueinander zeitlich versetzt sind.

16. Verfahren nach Anspruch 15, dadurch gekennzeichnet, daß nach dem Einspritzen (tᵢ) der einen Gruppe (I) zunächst die Kunststoffartikel der anderen Gruppe (II) aus deren vorausgegangenem Zyklus entformt (tₑ) werden, daß dann die andere Gruppe (II) eingespritzt (tᵢ) wird und danach die zuvor in der einen Gruppe (I) gespritzten Kunststoffartikel aus dieser entformt (tₑ) werden, wobei vorzugsweise nach dem Einspritzen (tᵢ) der einen Gruppe (I) vor dem Entformen (tₑ) der Kunststoffartikel der anderen Gruppe (II) zunächst der in die eine Gruppe (I) eingespritzte Kunststoff druckbehandelt (tₕ) und in einem vorgegebenen Ausmaß abgekühlt (t_{c}) wird, ehe das Werkzeug zum Entformen (tₑ) der Kunststoffartikel der anderen Gruppe geöffnet (tₐ, tₒ, t₂) wird.
